(19) Europäisches Patentamt / European Patent Office / Office européen des brevets

(11) **EP 3 920 238 B1**

(12) **EUROPEAN PATENT SPECIFICATION**

(45) Date of publication and mention of the grant of the patent:
**14.02.2024 Bulletin 2024/07**

(21) Application number: **20748560.8**

(22) Date of filing: **16.01.2020**

(51) International Patent Classification (IPC):
$H01L\ 29/786^{(2006.01)}$    $H01L\ 21/316^{(2006.01)}$
$H10K\ 10/46^{(2023.01)}$

(52) Cooperative Patent Classification (CPC):
**H10K 10/476; H10K 10/466**

(86) International application number:
**PCT/JP2020/001234**

(87) International publication number:
**WO 2020/158408 (06.08.2020 Gazette 2020/32)**

(54) **ORGANIC THIN-FILM TRANSISTOR AND METHOD FOR PRODUCING ORGANIC THIN-FILM TRANSISTOR**

ORGANISCHER DÜNNSCHICHTTRANSISTOR UND VERFAHREN ZUR HERSTELLUNG EINES ORGANISCHEN DÜNNSCHICHTTRANSISTORS

TRANSISTOR EN COUCHE MINCE ORGANIQUE, ET PROCÉDÉ DE FABRICATION DE CELUI-CI

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **01.02.2019 JP 2019016950**

(43) Date of publication of application:
**08.12.2021 Bulletin 2021/49**

(73) Proprietor: FUJIFILM Corporation
**Tokyo 106-8620 (JP)**

(72) Inventor: **IWASE, Eijiro**
**Minamiashigara-shi, Kanagawa 250-0193 (JP)**

(74) Representative: **Meissner Bolte Partnerschaft mbB**
**Patentanwälte Rechtsanwälte**
**Postfach 86 06 24**
**81633 München (DE)**

(56) References cited:
| | |
|---|---|
| WO-A1-2006/054686 | JP-A- 2004 327 857 |
| JP-A- 2006 196 879 | JP-A- 2013 036 733 |
| JP-A- 2015 088 715 | JP-A- 2015 177 100 |
| JP-A- 2016 111 218 | US-A1- 2010 237 337 |

**Description**

**BACKGROUND OF THE INVENTION**

1. Field of the Invention

The present invention relates to an organic thin film transistor and a method for manufacturing an organic thin film transistor, the method for manufacturing the organic thin film transistor.

2. Description of the Related Art

Unlike conventional inorganic semiconductors, an organic semiconductor is made of an organic molecule that can be dissolved in various solvents, and thus a thin film can be formed by a technique such as coating or printing. As a result, an organic semiconductor material can be used for various devices that are manufactured by a consecutive manufacturing process such as a roll-to-roll process.

Correspondingly, various organic thin film transistors using such organic semiconductors have been proposed.

The organic semiconductor film preferably has high mobility in terms of the switching speed of the organic thin film transistor and the like. However, in general, an organic semiconductor material has a property that the higher mobility the material exhibits, the lower the solubility of the material is in a solvent.

In addition, in the organic semiconductor film, the higher the film uniformity is, the higher mobility can be obtained. However, an organic semiconductor material has a low solubility in a solvent. Therefore, in a case where an organic semiconductor material is dissolved in a solvent to prepare a coating liquid, and then the coating liquid is applied, it is difficult to control drying and is difficult to form an organic semiconductor film having high uniformity.

On the other hand, it has been exemplified in the existing invention that the uniformity of the organic semiconductor film can be improved by matching the growth speed of the crystal with the drying speed of the coating liquid.

For example, JP2015-185620A discloses a film forming method for an organic semiconductor film, including a step 1 of dissolving an organic semiconductor in 3-chlorothiophene to prepare a coating liquid, a step 2 of preparing a substrate on which a contact member having an end surface that stands up with respect to a surface of the substrate is placed, a step 3 of supplying the prepared coating liquid to the substrate to form liquid droplet that comes into contact with the end surface of the contact member and a surface of the substrate at the same time, and a step 4 of evaporating 3-chlorothiophene from the liquid droplets that come into contact with the end surface of the contact member and the surface of the substrate at the same time.

In the film forming method for an organic semiconductor film disclosed in JP2015-185620A, the liquid droplet that comes into contact with the end surface of the contact member and the surface of the substrate are dried from the edge part on the side opposite to the contact member toward the contact member.

In this film forming method for an organic semiconductor film, the liquid droplet are gradually dried from the edge part toward the contact member to match the growth speed of the crystal with the drying speed of the coating liquid, which enables the formation of an organic semiconductor film having high uniformity.

Further, it is said that the organic semiconductor film is ideally in a state in which molecules of the organic semiconductor material are arranged vertically and parallelly. That is, in the film formation of the organic semiconductor film, the property of the surface to be formed is also an important factor of action, in addition to the control of the crystal growth in the plane direction by the drying control as described above.

Therefore, in a so-called bottom-gate type organic thin film transistor, a self-assembled monolayer film (a SAM film) is formed on a surface of the gate insulating film, which is the surface, to be formed, of the organic semiconductor film, for improving the uniformity of the organic semiconductor film.

The "state in which molecules of the organic semiconductor material are arranged vertically and parallelly" indicates a state in which the molecules of the organic semiconductor material stand in the film thickness direction and are arranged in the horizontal direction.

For example, JP2015-177100A discloses an organic thin film transistor, which is a bottom-gate type organic thin film transistor having a SAM film between a gate insulating film and an organic semiconductor film, the gate insulating film of which is made of alumina, and in which the chlorine concentration in the alumina is $1 \times 10^{20}$ atoms/cm$^3$ or more.

US2010/237337 (A1) discloses an OFET device comprising alumina gate insulating layer and SAM film.

**SUMMARY OF THE INVENTION**

In JP2015-177100A, the chlorine concentration in the gate insulating film is $1 \times 10^{20}$ atoms/cm$^3$ or more, which is higher than that of a general gate insulating film.

With such a configuration, JP2015-177100A says to realize the high density of the SAM film, which is obtained as a result of the fact that the chlorine in the gate insulating film enhances the reactivity with the SAM film formed on the surface of the gate insulating film. Further, it is said that the high density of the SAM film improves the crystallinity of the organic semiconductor film formed on the surface of the SAM film.

According to the organic thin film transistor disclosed in JP2015-177100A, the SAM film is densified regardless of the kind thereof, by adjusting the composition of the gate insulating film but not by densifying the SAM film. In JP2015-177100A, the densification of the SAM film can improve the crystallinity of the organic semiconductor film, whereby the mobility of the organic semiconductor film is improved.

However, the demand for the performance of the organic thin film transistor has become more stringent in recent years, and it is desired to realize an organic thin film transistor having an organic semiconductor film having higher crystal uniformity and higher mobility.

An object of the present invention is to solve such problems of the related art and to provide an organic thin film transistor having an organic semiconductor film having good uniformity and high mobility, and a method for manufacturing the organic thin film transistor.

According to the present invention, there is provided an organic thin film transistor according to claim 1, having an organic semiconductor film having good uniformity and high mobility, and a method for manufacturing said organic thin film transistor according to claim 6 with which the organic thin film transistor can be suitably manufactured.

## BRIEF DESCRIPTION OF THE DRAWINGS

Fig. 1 is a diagram conceptually illustrating an example of an organic thin film transistor according to the embodiment of the invention.

Fig. 2 is a conceptual diagram for explaining an example of a method for manufacturing an organic thin film transistor according to the embodiment of the invention.

Fig. 3 is a conceptual diagram for explaining an example of the method for manufacturing an organic thin film transistor according to the embodiment of the invention.

Fig. 4 is a conceptual diagram for explaining an example of the method for manufacturing an organic thin film transistor according to the embodiment of the invention.

Fig. 5 is a conceptual diagram for explaining an example of the method for manufacturing an organic thin film transistor according to the embodiment of the invention.

Fig. 6 is a conceptual diagram for explaining an example of the method for manufacturing an organic thin film transistor according to the embodiment of the invention.

## DESCRIPTION OF THE PREFERRED EMBODIMENTS

Hereinafter, an organic thin film transistor and a method for manufacturing an organic thin film transistor according to the embodiment of the invention will be described in detail based on suitable examples illustrated in the attached drawings.

A numerical value range represented using "to" in the present invention means a range including the numerical values described before and after "to" as the lower limit and the upper limit respectively.

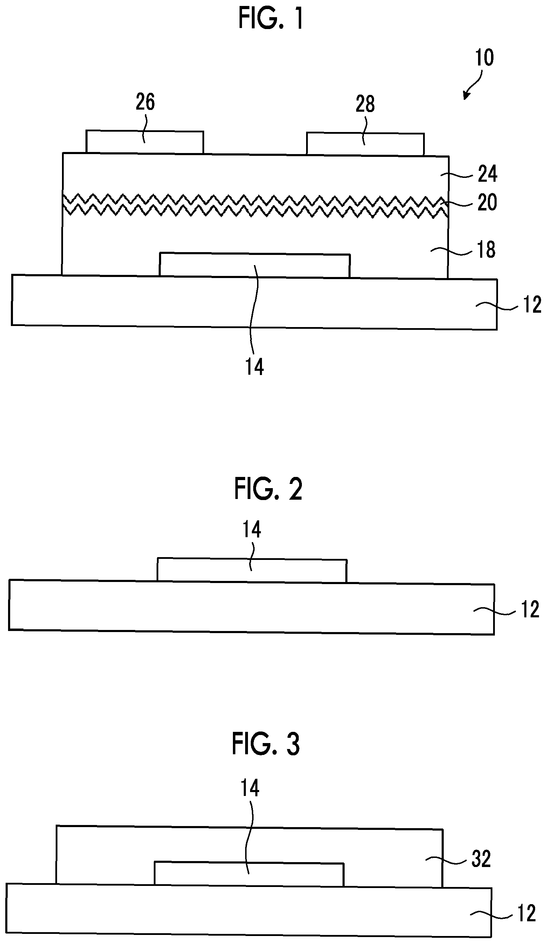

Fig. 1 conceptually illustrates an example of the organic thin film transistor according to the embodiment of the invention.

An organic thin film transistor 10 illustrated in Fig. 1 is a so-called bottom-gate and top-contact type organic thin film transistor, which includes a substrate 12, a gate electrode 14, a gate insulating film 18, a SAM film 20, an organic semiconductor film 24, and a source electrode 26 and a drain electrode 28. As described above, the SAM film 20 is a self-assembled monolayer film.

In the following description, for convenience, the substrate 12 side in the drawing is also referred to as the lower side, and the source electrode 26 and drain electrode 28 side is referred to as the upper side.

In the organic thin film transistor 10 according to the embodiment of the invention, the gate insulating film 18 is made of alumina, and a surface thereof, that is, the surface on the side of the SAM film 20 is boehmite. Thus, the surface of the gate insulating film 18 has an uneven structure due to boehmite. With such a configuration in the organic thin film transistor according to the embodiment of the invention, an organic semiconductor film having high uniformity is formed by forming the organic semiconductor film 24 on the surface of the SAM film 20 having high water repellency, as will be described later.

The organic thin film transistor 10 illustrated in Fig. 1 is a bottom-gate and top-contact type organic thin film transistor, which is a preferred configuration in which this effect can be more suitably obtained.

However, the present invention is not limited to this, and any organic thin film transistor can be used as an organic thin film transistor in various configurations as long as it is a bottom-gate type organic thin film transistor having an organic semiconductor film on the gate insulating film. Accordingly, the organic thin film transistor according to the embodiment of the invention may be a so-called bottom-gate and bottom-contact type organic thin film transistor, which has the source electrode 26 and the drain electrode 28 on the surface of the gate insulating film, and the organic semiconductor film 24 on the source electrode 26 and the drain electrode 28.

In the organic thin film transistor 10 according to the embodiment of the invention, the substrate 12 is not limited, and various substrates used in known organic thin film transistors can be used.

Examples of the substrate 12 include a resin film, a glass plate, and a silicon wafer.

Among them, the resin film is suitably exemplified. Examples of the resin film include a polyester film such as polyethylene naphthalate (PEN) or polyethylene terephthalate (PET), a cycloolefin polymer film, a polycarbonate film, a triacetyl cellulose (TAC) film, and a polyimide film. Further, a film obtained by sticking these resin films on glass or the like can also be used as the substrate 12.

The thickness of the substrate 12 is not limited.

The thickness of the substrate 12 is preferably 5 $\mu$m or more and more preferably 10 $\mu$m or more. On the other hand, the thickness of the substrate 12 is preferably 500 $\mu$m or less, more preferably 200 $\mu$m or less, and still more preferably 150 $\mu$m or less.

5 $\mu$m or more of the thickness of the substrate 12 is preferable in that sufficient strength can be secured, roll-to-roll transport is possible, handleability is good, and the like. 500 $\mu$m or less of the thickness of the substrate 12 is preferable in that the organic thin film transistor 10 having flexibility can be obtained, the organic thin film transistor 10 having a light weight can be obtained, and the like.

The gate electrode 14 is formed on the surface of the substrate 12.

The gate electrode 14 is the same as the gate electrode of the known bottom-gate type organic thin film transistor.

Accordingly, the material for forming the gate electrode 14 is not limited, and various known materials that are used as the gate electrode in the known organic thin film transistor can be used.

Examples of the material for forming the gate electrode 14 include metals such as platinum, gold, silver, aluminum, chromium, nickel, copper, molybdenum, titanium, magnesium, calcium, barium, sodium, palladium, iron, and manganese, conductive metal oxides such as $InO_2$, $SnO_2$, an indium tin oxide (ITO), a fluorine-doped tin oxide (FTO), an aluminum-doped zinc oxide (AZO), and a gallium-doped zinc oxide (GZO), conductive polymers such as polyaniline, polypyrrole, polythiophene, polyacetylene, and poly(3,4-ethylenedioxythiophene)/polystyrene sulfonic acid (PEDOT/PSS), the above-described conductive polymers to which a dopant, for example, an acid such as hydrochloric acid, sulfuric acid, or sulfonic acid, a Lewis acid such as $PF_6$, $AsF_5$, or $FeCl_3$, a halogen atom such as iodine, or a metal atom such as sodium or potassium is added, and conductive composite materials in which carbon black, graphite powder, metal fine particles, or the like is dispersed. These materials may be used alone, or two or more thereof may be used in any combination and in any ratio.

Further, the gate electrode 14 may be a configuration of one layer made of the above-described material or may be a configuration in which a plurality of layers made of the above-described material are laminated.

The thickness of the gate electrode 14 is not limited, and a thickness at which sufficient conductivity can be obtained may be appropriately set depending on the forming material.

The thickness of the gate electrode 14 is preferably 1 nm or more and more preferably 10 nm or more. The thickness of the gate electrode 14 is preferably 500 nm or less and more preferably 200 nm or less.

1 nm or more of the thickness of the gate electrode 14 is preferable in that sufficient conductivity can be ensured, in-plane uniformity can be maintained, the gate electrode does not have a sea and island structure, and the like. 500 nm or less of the thickness of the gate electrode 14 is preferable in that it is possible to prevent the gate electrode 14 from becoming unnecessarily thick, the peeling due to internal stress of the film is suppressed and thus adhesiveness can be maintained, bending is easily carried out, and the like.

The organic thin film transistor 10 has the gate insulating film 18, which completely covers the gate electrode 14.

In the organic thin film transistor 10 according to the embodiment of the invention, the gate insulating film 18 is made of alumina (aluminum oxide).

Further, in the organic thin film transistor 10 according to the embodiment of the invention, the surface (the surface layer) of the gate insulating film 18 is boehmite that is formed by the boehmite treatment of alumina. In other words, the gate insulating film 18 has a boehmite-treated boehmite film on the surface, which has been subjected to the boehmite treatment. Thus, the surface of the gate insulating film 18 has a fine uneven structure due to boehmite.

The surface of the gate insulating film 18 is the upper surface in the drawing, that is, the surface on the side of the source electrode 26 and the drain electrode 28.

The organic thin film transistor 10 according to the embodiment of the invention has the gate insulating film 18, which is made of alumina and the surface of which is boehmite. Thus, the gate insulating film 18 has fine unevenness due to boehmite on the surface. The organic thin film transistor 10 according to the embodiment of the invention has a SAM film 20 on the surface of the gate insulating film 18 having such fine unevenness and has an organic semiconductor film 24 on the surface of the SAM film 20.

With such a configuration, the present invention realizes a high-performance organic thin film transistor having an organic semiconductor film having high uniformity and high mobility.

In a case where the surface of alumina is subjected to the boehmite treatment, the surface of alumina becomes boehmite having a fine unevenness such as a so-called moth-eye structure and containing an alumina hydrate as the main component.

In a case where a water-repellent coating film is formed on such a fine uneven structure, the surface can be made extremely water-repellent. That is, in a case where a water-repellent coating film is formed on a surface having a fine unevenness like a moth-eye structure, the surface having very high water repellency like a lotus leaf, which exhibits the lotus effect, can be obtained.

The present invention utilizes this. That is, the organic thin film transistor 10 uses an alumina film as the gate insulating film 18, and the surface of the gate insulating film 18 becomes boehmite containing an alumina hydrate as the main component, which is formed by the alumite treatment and has a fine uneven structure like a moth-eye structure. In the organic thin film transistor 10 according to the embodiment of the invention, the SAM film 20 can be made into a water-repellent film having very high water repellency by forming the water-repellent SAM film 20 on the gate insulating film 18 having such a surface.

As will be described later, the organic semiconductor film 24 is formed by using a coating liquid obtained by dissolving an organic semiconductor material in a solvent. In a case where the coating liquid for forming the organic semiconductor film 24 is dropped on the surface of the SAM film 20 having very high water repellency, the liquid droplet of the coating liquid does not try to wettably spread but to try to maintain the sphere form. For this reason, the liquid droplet of the coating liquid has a large volume as compared with the surface area, so thus the drying speed becomes slow. As a result, the growth of the crystal film of the organic semiconductor film 24 becomes moderate, and the orientation of the molecules of the organic semiconductor material is easily aligned. As a result, the organic semiconductor film 24 can be made into an organic semiconductor film having high uniformity and/or high crystallinity and high mobility.

The gate insulating film of the organic thin film transistor is roughly classified into a coating type and an inorganic type.

The coating type is excellent in productivity. On the other hand, the coating type gate insulating film is made of a fluorine-based material in many cases, and thus it is difficult to apply a coating liquid in which an organic semiconductor material for subsequently forming the organic semiconductor film is dissolved.

Although the inorganic type is inferior in productivity, in the inorganic type, a film can be formed by a vapor phase film forming method such as sputtering or atomic layer deposition (ALD), and thus a dense film can be formed. However, the inorganic type gate insulating film is hydrophilic since it is made of an oxide in many cases. In a case where a coating liquid for forming an organic semiconductor film is applied onto a hydrophilic surface, the coating liquid wettably spread immediately and thinly, and thus the molecules of the organic semiconductor material are oriented in various directions and aggregated, whereby the performance is lowered. As a result, it is essential to form the SAM film on the surface of the inorganic gate insulating film.

On the other hand, in the improvement of the performance of the conventional organic semiconductor film, the study for organic semiconductor materials has been mainly carried out. For example, it has been studied to improve the controllability of drying by improving the solubility of the organic semiconductor material in a solvent to obtain an organic semiconductor film having high uniformity. However, since the solubility of the organic semiconductor material and the performance of the organic semiconductor material are essentially in the relation of trade-off, it has been difficult to improve the performance by improving the solubility.

On the other hand, in the present invention, the gate insulating film 18 is formed of alumina and the surface thereof has a fine uneven structure, and thus the water repellency of the SAM film 20 is improved and the organic semiconductor film 24 having good uniformity and high mobility is realized as described above.

That is, in the present invention, the performance improvement of the organic thin film transistor is realized from the study different in the direction from the conventional approach, which is not the conventional study of the material such as an organic semiconductor material but the study of the surface structure of the gate insulating film 18 from a viewpoint other than the material.

In the organic thin film transistor 10 according to the embodiment of the invention, the gate insulating film 18 is made of alumina and the surface thereof is boehmite. Thus, the gate insulating film 18 has a fine uneven structure due to boehmite on the surface.

There is no limitation on the surface roughness Ra of the gate insulating film 18. The surface roughness Ra of the gate insulating film 18 is preferably 3 to 70 nm, more preferably 5 to 50 nm, and still more preferably 10 to 25 nm.

3 nm or more of the surface roughness Ra of the gate insulating film 18 is preferable in that the SAM film 20 exhibits sufficient water repellency and the water repellency of the SAM film 20 can be prevented from becoming uneven. 70 nm or less of the surface roughness Ra of the gate insulating film 18 is preferable in that the damage to boehmite can be prevented and surface uniformity can be maintained.

The surface roughness Ra is an arithmetic mean roughness Ra and may be measured in accordance with JIS B 0601 (2001) using an atomic force microscope or the like.

The thickness of the gate insulating film 18 is not limited as long as the function as an insulating film can be exhibited. The thickness of the gate insulating film 18 is preferably 5 to 100 nm, more preferably 10 to 70 nm, and still more preferably 20 to 50 nm.

5 nm or more of the thickness of the gate insulating film 18 is preferable in that a uniform insulating film without pinholes can be formed and sufficient insulating properties can be stably secured.

100 nm or less of the thickness of the gate insulating film 18 is preferable in that the organic thin film transistor 10 having good flexibility can be obtained and the flexibility and the adhesiveness of the gate insulating film 18 can be increased.

The thickness of the gate insulating film 18 is most preferably within the above-described range including the unevenness of the surface; however, in a case where at least the thickness of the alumina region is within the above-described range, the above-described effect can be suitably obtained.

In the gate insulating film 18 according to the embodiment of the invention, the alumina region other than boehmite is preferably dense.

Specifically, the alumina region of the gate insulating film 18 preferably has a density of 2 g/cm$^3$ or more, more preferably 2.2 g/cm$^3$ or more, and still more preferably 2.5 g/cm$^3$ or more.

2 g/cm$^3$ or more of the density of the alumina region of the gate insulating film 18 is preferable in that boehmite can be suitably formed on the surface of the gate insulating film 18 by the boehmite treatment, insulating properties can be ensured, a gate insulating film having good flexibility, that is, the organic thin film transistor 10 can be obtained, and the like.

The SAM film 20 is formed on the surface of the gate insulating film 18.

The SAM film 20 is a known SAM film formed on an organic thin film transistor. However, in the organic thin film transistor 10 according to the embodiment of the invention, the SAM film 20 is formed on the surface of the gate insulating film 18 having unevenness on the surface, and thus it exhibits very high water repellency.

The material for forming the SAM film 20 is not limited, and various known materials that are used for the organic thin film transistor can be used as long as they are water-repellent. In the present invention, the water repellency is, in other words, the liquid repellency to the coating liquid that forms the organic semiconductor film described later.

Suitable examples of the material for forming the SAM film 20 include silane compounds such as trimethoxy(2-phenylethyl)silane, methyl trichlorosilane, ethyl trichlorosilane, butyl trichlorosilane, octyl trichlorosilane, decyl trichlorosilane, octadecyl trichlorosilane, phenethyl trichlorosilane, methyl trimethoxysilane, ethyl trimethoxysilane, butyl trimethoxysilane, octyl trimethoxysilane, decyl trimethoxysilane, octadecyl trimethoxysilane, and trimethoxyphenyl ethyl silane.

Among them, trimethoxy(2-phenylethyl)silane is suitably used as the SAM film 20.

The thickness of the SAM film 20 is not limited.

The thickness of the SAM film 20 is generally about 1 to 3 nm as the thickness of molecule of the compound that is used to form the SAM film in many cases.

The organic semiconductor film 24 is formed on the surface of the SAM film 20.

The material for forming the organic semiconductor film 24 is not limited, and various known organic semiconductor materials that are used for the organic thin film transistor can be used.

Examples of the organic semiconductor material include a pentacene derivative such as 6,13-bis(triisopropylsilylethynyl)pentacene (TIPS pentacene), an anthradithiophene derivative such as 5,11-bis(triethylsilylethynyl)anthradithiophene (TES-ADT), a benzodithiophene (BDT) derivative, a benzothienobenzothiophene (BTBT) derivative such as dioctylbenzothienobenzothiophene (C8-BTBT), a dinaphthothienothiophene (DNTT) derivative, a dinaphthobenzodithiophene (DNBDT) derivative, a 6,12-dioxaanthanthrene (perixanthenoxanthene) derivative, a naphthalene tetracarboxylic acid diimide (NTCDI) derivative such as N,N'-bis(cyclohexyl)naphthalene-1,4,5,8-bis(dicarboxyimide), a perylene tetracarboxylic acid diimide (PTCDI) derivative, a polythiophene derivative, a poly(2,5-bis(thiophen-2-yl)thieno[3,2-b]thiophene) (PBTTT) derivative, a tetracyanoquinodimethane (TCNQ) derivative, oligothiophenes, phthalocyanins, and fullerenes.

Further, as the organic semiconductor material, the organic semiconductor materials described in paragraphs [0063] to [0160] of JP2015-170760A, the organic semiconductor material disclosed in JP2015-195361A, and the organic semiconductor material disclosed in JP2018-006745A can be also suitably used.

The film thickness of the organic semiconductor film 24 is not limited. That is, the film thickness of the organic semiconductor film 24 may be appropriately set to a film thickness with which the target performance can be exhibited, depending on the material for forming the organic semiconductor film 24.

The film thickness of the organic semiconductor film 24 is preferably 1 to 200 nm, more preferably 2 to 100 nm, and still more preferably 10 to 50 nm.

1 nm or more of the thickness of the organic semiconductor film 24 is preferable in that, for example, one or more molecules of the organic semiconductor film 24 can be aligned in the vertical direction to stably exhibit the target performance.

200 nm or less of the thickness of the organic semiconductor film 24 is preferable in that the organic thin film transistor 10 having good flexibility can be obtained, the organic semiconductor film 24 can be prevented from becoming unnecessarily thick, the cost can be reduced, and the like.

The source electrode 26 and the drain electrode 28 are formed on the surface of the organic semiconductor film 24. The source electrode 26 and the drain electrode 28 are the same as the source electrode and drain electrode of the known bottom-gate type organic thin film transistor.

Accordingly, the materials forming the source electrode 26 and the drain electrode 28 are not limited, and various known materials that are used as the source electrode and the drain electrode in the known organic thin film transistor can be used.

Examples of the materials forming the source electrode 26 and the drain electrode 28 include various materials exemplified in the gate electrode 14.

The thicknesses of the source electrode 26 and the drain electrode 28 are not limited, and thicknesses at which sufficient conductivity can be obtained may be appropriately set depending on the forming materials.

The thicknesses of the source electrode 26 and the drain electrode 28 are each preferably 1 nm or more and more preferably 10 nm or more. The thicknesses of the source electrode 26 and the drain electrode 28 are each preferably 500 nm or less and more preferably 200 nm or less.

1 nm or more of the thicknesses of the source electrode 26 and the drain electrode 28 is preferable in that sufficient conductivity can be ensured. 500 nm or less of the thicknesses of the source electrode 26 and the drain electrode 28 is preferable in that it is possible to prevent the source electrode 26 and the drain electrode 28 from becoming unnecessarily thick, the adhesiveness of the source electrode 26 and the adhesiveness of the drain electrode 28 can be secured, an organic thin film transistor having good flexibility can be obtained, and the like.

Hereinafter, an example of the method for manufacturing an organic thin film transistor according to the embodiment of the invention, with which the organic thin film transistor according to the embodiment of the invention illustrated in Fig. 1 is manufactured, will be described with reference to Figs. 2 to 6.

First, as conceptually illustrated in Fig. 2, the substrate 12 as described above is prepared, and the gate electrode 14 is formed on the surface of the substrate 12.

The method of forming the gate electrode 14 is not limited, and various methods that are used for forming a gate electrode in the manufacture of the organic thin film transistor can be used depending on the material for forming the gate electrode 14.

Examples of the method forming the gate electrode 14 include physical vapor deposition (PVD) such as vacuum deposition and sputtering, chemical vapor deposition (CVD), plasma CVD, a coating method, a printing method, a transfer method, a sol-gel method, and a plating method.

At the time of forming the gate electrode 14, as necessary, the gate electrode 14 may be patterned into a desired shape by a known method such as masking. Alternatively, as necessary, a conductive film formed by these methods may be patterned into a desired shape to form the gate electrode 14.

In the coating method, a solution, paste, or a dispersion liquid of the above-described materials can be prepared and used for coating, and a film can be formed or an electrode can be directly formed by drying, baking, photocuring, or aging. Examples of the coating method include a spin coating method, a die coating method, a microgravure coating method, and a dip coating method.

Further, a desired patterning can be carried out by printing methods such as an inkjet printing method, a screen printing method, a (reversal) offset printing method, a relief printing method, an intaglio printing method, a plate printing method, a thermal transfer printing method, and a microcontact printing method, which are preferable in terms of process simplification, cost reduction, speeding up, and the like.

Examples of the patterning method for the formed film include a photolithography method.

Examples of the photolithography method include a method in which patterning of a photoresist is combined with etching such as wet etching using an etching solution or dry etching using a reactive plasma, a lift-off method, or the like.

In the lift-off method, a resist is applied onto a part of the base, a conductive material is formed into a film on the resist, and the resist or the like is eluted or peeled off with a solvent thereby removing the entire conductive material on the resist, whereby a film is formed only on the part which has not been coated with the resist.

Other examples of the patterning method include a method in which the formed film is irradiated with energy rays such as a laser and an electron beam to polish the film or to change the conductivity of the material.

Further, another example thereof includes a method in which a composition for the gate electrode, printed on a base material other than the substrate 12 is transferred.

Next, as conceptually illustrated in Fig. 3, an alumina film 32 is formed on the surface of the substrate 12 to cover the gate electrode 14.

The method forming the alumina film 32 is not limited, and various known methods forming an alumina film can be used. PVD such as vacuum deposition and sputtering, CVD, plasma CVD, and a vapor phase film forming method (a gas phase deposition method) such as ALD are suitably used in that the dense alumina film 32 can be formed. Among them, sputtering and ALD are more preferably used since the alumina film 32, which is very dense, can be formed.

The alumina film 32 may be patterned as necessary.

The patterning of the alumina film 32 may be carried out by a known method. As an example thereof, various methods exemplified as the patterning method for the gate electrode 14 can be used.

The patterning may be carried out in a state in which the gate insulating film 18 that has been subjected to the boehmite treatment described later has an uneven surface which is boehmite.

After the alumina film 32 is formed, the surface of the alumina film 32 is subsequently subjected to the boehmite treatment. As a result, the alumina film 32 becomes the gate insulating film 18 consisting of an alumina film, which has an uneven surface of boehmite (a boehmite film).

The method for the boehmite treatment is not limited, and various known methods that are used for the boehmite treatment of alumina films can be used. Examples thereof include water vapor treatment, warm water treatment (warm water immersion treatment), and hot water treatment (hot water immersion treatment).

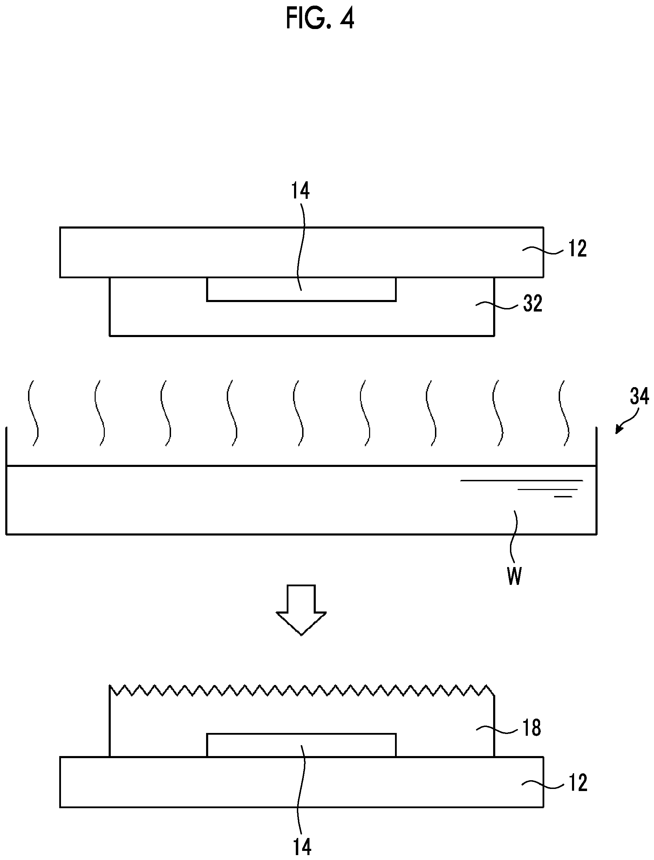

As an example thereof, water W is put into a water bath 34 as conceptually illustrated in Fig. 4. In all boehmite treatments, the water for carrying out the boehmite treatment is preferably pure water or ion exchang water.

Next, the substrate 12 on which the alumina film 32 is formed is arranged so that the alumina film 32 faces the water W. Then, the water W in the water bath 34 is boiled, and water vapor is applied to the alumina film 32 to carry out the boehmite treatment by water vapor treatment. The boehmite treatment time may be set as appropriate.

As a result, as illustrated in the lower part of Fig. 4, the gate insulating film 18 made of an alumina film is formed, where gate insulating film 18 has an uneven surface which is boehmite.

The surface roughness Ra of the gate insulating film 18 formed by the boehmite treatment can be controlled by the treatment time of the boehmite treatment, the amount of water vapor to which alumina is exposed in the water vapor treatment, the water temperature in the warm water treatment and the hot water treatment, and the like.

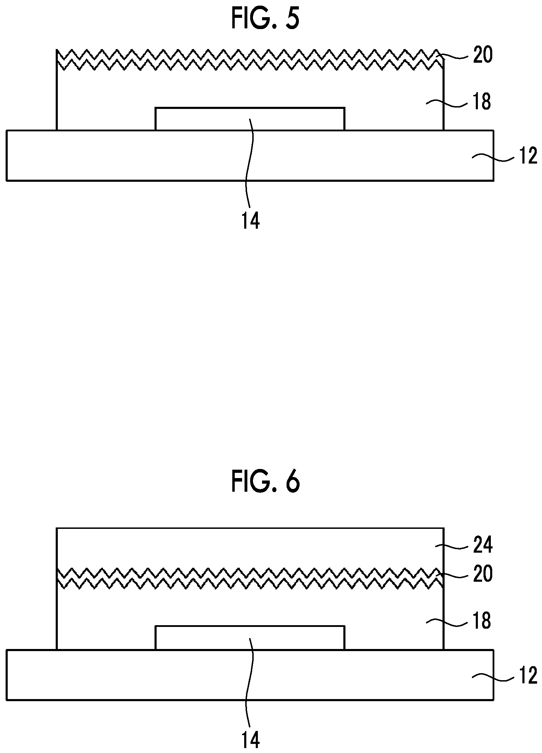

After the gate insulating film 18 is formed, the SAM film 20 is formed on the surface of the gate insulating film 18 as conceptually illustrated in Fig. 5.

The method forming the SAM film 20 is also not limited, and various methods that are used forming the SAM film 20 in the manufacture of the organic thin film transistor can be used depending on the material for forming the SAM film 20.

Examples thereof include a method of vaporizing the material for forming the SAM film 20 and exposing the surface of the gate insulating film 18 to the vapor, vacuum deposition, a method of immersing the surface of the gate insulating film 18 in a liquid containing the material for forming the SAM film 20, and Langmuir-Blodgett method.

After the SAM film 20 is formed, the organic semiconductor film 24 is formed on the surface of the SAM film 20 as conceptually illustrated in Fig. 6.

The method forming the organic semiconductor film 24 is also not limited, and various methods that are used forming the organic semiconductor film in the manufacture of the organic thin film transistor can be used depending on the material for forming the organic semiconductor film 24.

Preferred examples of the method forming the organic semiconductor film 24 include a coating method. That is, it is preferable to prepare a coating liquid obtained by dissolving the organic semiconductor material in a solvent, coat the surface of the SAM film 20 with the coating liquid, and dry the coating film to form the organic semiconductor film 24. The concentration of the organic semiconductor material in the coating liquid is preferably high.

As the solvent, a solvent capable of dissolving the organic semiconductor material may be appropriately selected depending on the organic semiconductor material to be formed into a film.

For example, in a case where the organic semiconductor material is C8-BTBT, TIPS pentacene, TES-ADT, or the like, preferred examples of the solvent include aromatic compounds such as toluene, xylene, mesitylene, 1,2,3,4-tetrahydronaphthalene (tetralin), chlorobenzene, dichlorobenzene, and anisole.

The coating method is also not limited, and various known coating methods can be used.

Examples thereof include printing methods such as an inkjet method, a gravure printing method, and a screen printing method, coating methods such as a spin coating method, a die coating method, and a dip coating method, and spray coating such as ultrasonic spraying and two-fluid spraying.

The organic semiconductor film 24 may also be patterned by known methods such as the method exemplified in the formation of the gate electrode 14.

After the organic semiconductor film 24 is formed, the source electrode 26 and the drain electrode 28 are formed on the surface of the organic semiconductor film 24 to obtain the organic thin film transistor according to the embodiment of the invention as illustrated in Fig. 1.

The method forming the source electrode 26 and the drain electrode 28 is also not limited, and various methods that are used forming the source electrode and the drain electrode in the manufacture of the organic thin film transistor can be used depending on the materials forming the source electrode 26 and the drain electrode 28.

As an example, the formation of the source electrode 26 and the drain electrode 28 may be carried out according to the method forming the gate electrode 14 described above.

The manufacturing method according to the embodiment of the invention may be a batch type (a sheet type) method in which the organic thin film transistors are manufactured one by one. Alternatively, the manufacturing method according to the embodiment of the invention may be a method in which a plurality of organic thin film transistors are consecutively manufactured while relatively moving the substrate 12 and the treatment unit. Alternatively, the manufacturing method according to the embodiment of the invention may be a method in which a manufacturing step such as the batch type step is mixed with a consecutive manufacturing step in which the substrate 12 and the treatment unit are relatively moved.

Further, in the manufacturing method according to the embodiment of the invention, in a case where the substrate 12 is a long sheet-shaped substrate, roll-to-roll (RtoR) can also be used. As is well known, RtoR is a manufacturing method in which a substrate is sent out from a roll around which the substrate Z is wound, a treatment is carried out while transporting the substrate Z in the longitudinal direction, and the treated substrate Z is wound in a roll shape.

Basically, in the manufacturing method according to the embodiment of the invention, it is not necessary to provide a member other than the constitutional elements of the organic thin film transistor on the substrate 12 or the like, such as a contact member that is provided on the surface of the substrate 12, unlike the case of the method disclosed in JP2015-185620A. As a result, the manufacturing method according to the embodiment of the invention can suitably cope with a consecutive manufacturing method such as RtoR in which the substrate 12 and the treatment unit are relatively moved.

The organic thin film transistor and the method for manufacturing the organic thin film transistor according to the embodiment of the invention have been described in detail above.

Examples

Hereinafter, the present invention will be described specifically with reference to Examples. The present invention is not limited to the specific examples described below.

[Example 1]

As a substrate, a PEN film (Teonex Q65, manufactured by TEIJIN LIMITED) having a thickness of 100 $\mu$m and having no undercoat layer was prepared.

A mask was placed on the surface of the substrate, and a gold thin film having a thickness of 50 nm was formed as a gate electrode by sputtering that targeted gold.

An alumina film having a thickness of 20 nm was formed on the entire surface of the substrate so that the gate electrode was covered, by sputtering that targeted aluminum and used oxygen gas and argon gas.

A glass petri dish was placed on a hot plate, and pure water was added to the petri dish. The substrate was arranged so that the alumina film faced the pure water.

Then, the temperature of the hot plate was set to 150°C, the pure water was boiled, and the surface of the alumina film was exposed to water vapor (steam) for 15 minutes to perform the boehmite treatment of the alumina film.

In this manner, a gate insulating film made of alumina was formed, where the gate insulating film had an uneven surface which was boehmite.

The surface of the gate insulating film was observed under an atomic force microscope to measure the surface roughness Ra. As a result of the measurement, the surface roughness Ra of the gate insulating film was 10 nm.

1 milliliter (mL) of trimethoxy(2-phenylethyl)silane (manufactured by Tokyo Chemical Industry Co., Ltd.) was added to a glass bottle. The glass bottle and the substrate on which the gate insulating film was formed were placed in an oven.

The oven in which the glass bottle and the substrate were placed was heated at 130°C for 3 hours. In this manner, the surface of the gate insulating film was coated with vaporized trimethoxy(2-phenylethyl)silane, and a SAM film made of trimethoxy(2-phenylethyl)silane was formed on the surface of the gate insulating film (boehmite).

An organic semiconductor material (C8-BTBT, manufactured by Sigma-Aldrich Co., LLC) was dissolved in benzene to prepare a coating liquid having a concentration of 1% by mass of the organic semiconductor material.

The surface of the SAM film was coated with the prepared coating liquid by an ultrasonic spray coating device (manufactured by Sono-Tek Corporation).

After coating, drying was carried out in an oven at 130°C for 1 hour to form an organic semiconductor film having a thickness of 20 nm.

A mask was placed on the surface of the organic semiconductor film, and a gold thin film was formed as a source electrode and a drain electrode by sputtering that targeted gold, to make an organic thin film transistor.
Each of the source electrode and the drain electrode had a channel length of 30 μm, a thickness of 50 nm, and a channel width of 10 mm.

[Example 2]

An organic thin film transistor was manufactured in the same manner as in Example 1 except that the film thickness of the alumina film forming the gate insulating film was set to 5 nm and the boehmite treatment time was changed to 3 minutes.
As a result of the measurement carried out in the same manner as in Example 1, the surface roughness Ra of the gate insulating film was 3 nm.

[Example 3]

An organic thin film transistor was manufactured in the same manner as in Example 1 except that the film thickness of the alumina film forming the gate insulating film was set to 40 nm and the boehmite treatment time was changed to 30 minutes.
As a result of the measurement carried out in the same manner as in Example 1, the surface roughness Ra of the gate insulating film was 20 nm.

[Example 4]

An organic thin film transistor was manufactured in the same manner as in Example 1 except that the film thickness of the alumina film forming the gate insulating film was set to 20 nm and the boehmite treatment time was changed to 3 minutes.
As a result of the measurement carried out in the same manner as in Example 1, the surface roughness Ra of the gate insulating film was 3 nm.

[Example 5]

An organic thin film transistor was manufactured in the same manner as in Example 1 except that the film thickness of the alumina film forming the gate insulating film was set to 20 nm and the boehmite treatment time was changed to 15 minutes.
As a result of the measurement carried out in the same manner as in Example 1, the surface roughness Ra of the gate insulating film was 25 nm.

[Comparative Example 1]

An organic thin film transistor was manufactured in the same manner as in Example 1 except that the alumina film was not subjected to the boehmite treatment. That is, in this example, a general alumina film, the surface of which is not boehmite, is the gate insulating film.
As a result of the measurement carried out in the same manner as in Example 1, the surface roughness Ra of the gate insulating film (the alumina film) was 0.1 nm.

<Evaluation of mobility>

The carrier mobility of the manufactured organic thin film transistor was measured by the following method.
A voltage of -40 V was applied between the source electrode and the drain electrode, the gate voltage was changed in a range of 40 V to -40 V, and the carrier mobility μ was calculated using the following expression representing the drain current Id.

$$Id = (w/2L)\,\mu Ci\,(Vg - Vth)^2$$

(In the expression, L is the gate length, w is the gate width, Ci is the capacitance per unit area of the insulating film, Vg is the gate voltage, and Vth is the threshold voltage).
The carrier mobility was evaluated according to the following evaluation standard.

A: Carrier mobility is 0.05 cm$^2$/Vs or more.
B: Carrier mobility is 0.025 cm$^2$/Vs or more and less than 0.05 cm$^2$/Vs.
C: Carrier mobility is 0.01 cm$^2$/Vs or more and less than 0.025 cm$^2$/Vs.
D: Carrier mobility is 0.005 cm$^2$/Vs or more and less than 0.01 cm$^2$/Vs.
E: Carrier mobility is less than 0.005 cm$^2$/Vs.

The results are shown in the table below.

[Table 1]

|  | Gate insulating film | | Evaluation of mobility |
|---|---|---|---|
|  | Alumina film thickness [nm] | Surface roughness Ra [nm] |  |
| Example 1 | 20 | 10 | A |
| Example 2 | 5 | 3 | C |
| Example 3 | 40 | 20 | B |
| Example 4 | 20 | 3 | C |
| Example 5 | 20 | 25 | B |
| Comparative Example 1 | 20 | 0.1 | E |

As shown in the above table, the organic thin film transistor according to the embodiment of the invention, in which the surface of the gate insulating film is boehmite and has an uneven structure, has the organic semiconductor film having good mobility as compared with Comparative Example in which the gate insulating film is general alumina.

The film thickness of the gate insulating film is presumed to be roughly equal to the sum of the film thickness of the formed alumina and the surface roughness Ra of the gate insulating film. As shown in Examples 1, 3, and 5, in a case where the surface roughness Ra of the gate insulating film is set to 10 to 25 nm, the mobility of the organic semiconductor film can be further increased.

From the above results, the effects of the present invention are clear.

Explanation of References

10: organic thin film transistor
12: substrate
14: gate electrode
18: gate insulating film
20: self-assembled monolayer film (SAM film)
24: organic semiconductor film
26: source electrode
28: drain electrode
32: alumina film
34: water bath
W: water

Claims

1.  An organic thin film transistor comprising:

a gate electrode (14);
a gate insulating film (18) that is provided to cover the gate electrode;
a self-assembled monolayer film (20) that is provided on the surface of the gate insulating film; and
an organic semiconductor film (24), a source electrode (26), and a drain electrode (28), which are provided on a side of the self-assembled monolayer film opposite to the gate insulating film,
wherein the gate insulating film is made of alumina, and **characterized in that**

a surface of the gate insulating film is boehmite.

2. The organic thin film transistor according to claim 1,
   wherein the gate insulating film has a thickness of 5 to 100 nm.

3. The organic thin film transistor according to claim 1 or 2,
   wherein a surface roughness Ra of the gate insulating film is 3 to 70 nm.

4. The organic thin film transistor according to any one of claims 1 to 3,

   wherein the organic semiconductor film is provided on a surface of the self-assembled monolayer film, and
   the source electrode and the drain electrode are provided on a surface of the organic semiconductor film.

5. The organic thin film transistor according to any one of claims 1 to 4,
   wherein the self-assembled monolayer film is trimethoxy(2-phenylethyl)silane.

6. A method for manufacturing an organic thin film transistor according to claim 1, comprising:

   a step of forming a gate electrode on a surface of a substrate;
   a step of covering the gate electrode to form an alumina film;
   a step of subjecting a surface of the alumina film to a boehmite treatment so that the surface of the alumina film is boehmite, thereby forming a gate insulating film;
   a step of forming a self-assembled monolayer film on a surface of the gate insulating film; and
   a step of forming an organic semiconductor film, a source electrode, and a drain electrode on a side of the self-assembled monolayer film opposite to the gate insulating film.

7. The method for manufacturing an organic thin film transistor according to claim 6,

   wherein the organic semiconductor film is formed on a surface of the self-assembled monolayer film, and
   the source electrode and the drain electrode are formed on a surface of the organic semiconductor film.


**Patentansprüche**

1. Organischer Dünnschichttransistor, umfassend:

   eine Gate-Elektrode (14);
   einen Gate-Isolierfilm (18), der vorgesehen ist, die Gate-Elektrode zu bedecken;
   einen selbstorganisierenden Monoschicht-Film (20), der auf der Oberfläche des Gate-Isolierfilms vorgesehen ist; und
   einen organischen Halbleiterfilm (24), eine Source-Elektrode (26) und eine Drain-Elektrode (28), die auf einer dem Gate-Isolierfilm gegenüberliegenden Seite des selbstorganisierenden Monoschicht-Films vorgesehen sind,
   wobei der Gate-Isolierfilm aus Aluminiumoxid hergestellt ist, und
   **dadurch gekennzeichnet, dass** eine Oberfläche des Gate-Isolierfilms Böhmit ist.

2. Organischer Dünnschichttransistor gemäß Anspruch 1, wobei der Gate-Isolierfilm eine Dicke von 5 bis 100 nm aufweist.

3. Organischer Dünnschichttransistor gemäß Anspruch 1 oder 2, wobei die Oberflächenrauhigkeit Ra des Gate-Isolierfilms 3 bis 70 nm beträgt.

4. Organischer Dünnschichttransistor gemäß einem der Ansprüche 1 bis 3,

   wobei der organische Halbleiterfilm auf einer Oberfläche des selbstorganisierenden Monoschicht-Films vorgesehen ist, und
   die Source-Elektrode und die Drain-Elektrode auf einer Oberfläche des organischen Halbleiterfilms vorgesehen sind.

**5.** Organischer Dünnschichttransistor gemäß einem der Ansprüche 1 bis 4, wobei der selbstorganisierenden Monoschicht-Film Trimethoxy(2-phenylethyl)silan ist.

**6.** Verfahren zur Herstellung eines organischen Dünnschichttransistors gemäß Anspruch 1, umfassend:

einen Schritt des Bildens einer Gate-Elektrode auf einer Oberfläche eines Substrats;
einen Schritt des Bedeckens der Gate-Elektrode, um einen Aluminiumoxidfilm zu bilden;
einen Schritt, des Unterziehens einer Oberfläche des Aluminiumoxidfilms einer Böhmit-Behandlung, so dass die Oberfläche des Aluminiumoxidfilms Böhmit ist, wodurch ein Gate-Isolierfilm gebildet wird;
einen Schritt der Bildung eines selbstorganisierenden Monoschicht-Films auf einer Oberfläche des Gate-Isolierfilms; und
einen Schritt des Bildens eines organischen Halbleiterfilms, einer Source-Elektrode und einer Drain-Elektrode auf einer Seite des selbstorganisierenden Monoschicht-Films gegenüber dem Gate-Isolierfilm.

**7.** Verfahren zur Herstellung eines organischen Dünnschichttransistors gemäß Anspruch 6,

wobei der organische Halbleiterfilm auf einer Oberfläche des selbstorganisierenden Monoschicht-Films gebildet wird, und
die Source-Elektrode und die Drain-Elektrode auf einer Oberfläche des organischen Halbleiterfilms ausgebildet werden.

**Revendications**

**1.** Transistor organique à couches minces comprenant :

une électrode de grille (14) ;
un film isolant de grille (18) qui est prévu pour recouvrir l'électrode de grille ;
un film monocouche auto-assemblé (20) qui est prévu sur la surface du film isolant de grille ; et
un film semi-conducteur organique (24), une électrode de source (26) et une électrode de drain (28) qui sont prévus sur un côté du film monocouche auto-assemblé opposé au film isolant de grille,
dans lequel le film isolant de grille est constitué d'alumine, et **caractérisé en ce que**
une surface du film isolant de grille est en boehmite.

**2.** Transistor organique à couches minces selon la revendication 1,
dans lequel le film isolant de grille a une épaisseur de 5 à 100 nm.

**3.** Transistor organique à couches minces selon la revendication 1 ou 2,
dans lequel une rugosité de surface Ra du film isolant de grille est comprise entre 3 et 70 nm.

**4.** Transistor organique à couches minces selon l'une quelconque des revendications 1 à 3,

dans lequel le film semi-conducteur organique est prévu sur une surface du film monocouche auto-assemblé, et
l'électrode de source et l'électrode de drain sont prévues sur une surface du film semi-conducteur organique.

**5.** Transistor organique à couches minces selon l'une quelconque des revendications 1 à 4,
dans lequel le film monocouche auto-assemblé est du triméthoxy(2-phényléthyl)silane.

**6.** Procédé de fabrication d'un transistor organique à couches minces selon la revendication 1, comprenant :

une étape consistant à former une électrode de grille sur une surface d'un substrat ;
une étape consistant à recouvrir l'électrode de grille pour former un film d'alumine ;
une étape consistant à soumettre une surface du film d'alumine à un traitement à la boehmite de sorte que la surface du film d'alumine soit en boehmite, formant ainsi un film isolant de grille ;
une étape consistant à former un film monocouche auto-assemblé sur une surface du film isolant de grille ; et
une étape consistant à former un film semi-conducteur organique, une électrode de source et une électrode de drain sur un côté du film monocouche auto-assemblé opposé au film isolant de grille.

7. Procédé de fabrication d'un transistor organique à couches minces selon la revendication 6,

dans lequel le film semi-conducteur organique est formé sur une surface du film monocouche auto-assemblé, et l'électrode de source et l'électrode de drain sont formées sur une surface du film semi-conducteur organique.

## FIG. 1

## FIG. 2

## FIG. 3

# FIG. 4

## FIG. 5

## FIG. 6

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2015185620 A
- JP 2015177100 A
- US 2010237337 A1
- JP 2015170760 A
- JP 2015195361 A
- JP 2018006745 A